(19) Europäisches Patentamt
European Patent Office
Office européen des brevets

(11) **EP 1 062 728 B1**

(12) **EUROPÄISCHE PATENTSCHRIFT**

(45) Veröffentlichungstag und Bekanntmachung des Hinweises auf die Patenterteilung:
**02.05.2002  Patentblatt 2002/18**

(51) Int Cl.⁷: **H03K 7/08**

(21) Anmeldenummer: **99910146.2**

(22) Anmeldetag: **19.02.1999**

(86) Internationale Anmeldenummer:
**PCT/DE99/00463**

(87) Internationale Veröffentlichungsnummer:
**WO 99/48204 (23.09.1999 Gazette 1999/38)**

(54) **SCHALTUNGSANORDNUNG ZUR ANSTEUERUNG EINES PULSWEITENMODULATORS IN EINEM SCHALTNETZTEIL**

CIRCUIT FOR CONTROLLING A PULSE WIDTH MODULATOR IN A SWITCHED-MODE POWER SUPPLY

CIRCUIT POUR COMMANDER UN MODULATEUR DE LARGEUR D'IMPULSION DANS UNE ALIMENTATION A DECOUPAGE

(84) Benannte Vertragsstaaten:
**DE DK ES FI FR GB IT NL**

(30) Priorität: **17.03.1998  DE 19811605**

(43) Veröffentlichungstag der Anmeldung:
**27.12.2000  Patentblatt 2000/52**

(73) Patentinhaber: **Infineon Technologies AG**
**81669 München (DE)**

(72) Erfinder: **NIEDERREITER, Hans**
**D-84453 Mühldorf (DE)**

(74) Vertreter: **Banzer, Hans-Jörg, Dipl.-Ing.**
**Kraus & Weisert**
**Patent- und Rechtsanwälte**
**Thomas-Wimmer-Ring 15**
**80539 München (DE)**

(56) Entgegenhaltungen:
**US-A- 4 007 361       US-A- 4 238 695**
**US-A- 4 272 690       US-A- 4 532 435**
**US-A- 5 113 158       US-A- 5 594 631**

**Beschreibung**

Die vorliegende Erfindung betrifft eine Schaltungsanordnung zur Ansteuerung eines Pulsweitenmodulators in einem Schaltnetzteil mit einer Differenzbildungsstufe zur Bildung eines Differenzsignals aus einem einer ersten Eingangsklemme zuführbaren Regelsignal und einem einer zweiten Eingangsklemme zuführbaren Referenzsignal und zur Erzeugung eines an einer Ausgangsklemme abgreifbaren Ansteuersignals durch Verstärkung des Differenzsignals um einen Verstärkungsfaktor k.

Aufgabe des Pulsweitenmodulators in Schaltnetzteilen ist die Erzeugung von Ansteuerimpulsen für einen in Reihe zur Primärspule eines Übertragers geschalteten Halbleiterleistungsschalter. Die Frequenz und Dauer der Ansteuerimpulse bestimmt die von der Primärspule, und damit von dem Schaltnetzteil, aufgenommene Leistung, die wiederum an eine sekundärseitig an dem Übertrager angeschlossene veränderliche Last abgegeben wird. Während des Betriebs soll die über der Last abfallende Spannung möglichst lastunabhängig konstant gehalten werden. Dies erfordert eine Reduktion der Leistungsaufnahme, und damit der Frequenz und/oder Dauer der Ansteuerimpulse, bei Reduktion der Last und eine Erhöhung der Leistungsaufnahme, und damit der Frequenz und/oder Dauer der Ansteuerimpulse, bei Erhöhung der Last.

Das von der Differenzbildungsstufe an den Pulsweitenmodulator gelieferte Ausgangssignal dient zur Einstellung der Dauer und/oder Frequenz der von dem Pulsweitenmodulator gelieferten Ansteuerimpulse. Im Falle festgetakteter Schaltnetzteile erfolgt die Generierung der Ansteuerimpulse in dem Pulsweitenmodulator beispielweise mittels eines Sägezahngenerators, wobei die Ansteuerimpulse mit ansteigenden Flanken des generierten Sägezahnsignals beginnen und enden, wenn die Amplitude des Sägezahnsignals die Amplitude des von der Differenzbildungsstufe gelieferten Ausgangsignals übersteigt.

Durch Laständerungen bedingte Schwankungen der Aussangsspannung werden durch das von der Ausgangsspannung abhängige Regelsignal an die Differenzbildungsstufe zurückgeliefert, in der das Regelsignal mit dem Referenzsignal verglichen und das Ansteuersignal solange nachgeregelt wird, bis sich die gewünschte Ausgangsspannung bzw. zwischen dem Regelsignal und dem Referenzsignal eine minimal mögliche Differenz einstellt.

Die als Regler wirkende Differenzbildungsstufe besteht bei bekannten Schaltnetzteilen im einfachsten Fall aus einem Differenzverstärker zur Bildung eines Differenzsignals aus dem Regelsignal und dem Referenzsignal bei anschließender Verstärkung des Differenzsignals um einen konstanten Verstärkungsfaktor. Durch zusätzliche Schaltungsmaßnahmen kann aus dem Differenzverstärker, der für sich ein proportionales Regelverhalten besitzt, ein Regler mit einem integralen oder einem proportional-integralen Regelverhalten gebildet werden.

Unabhängig davon, ob die Differenzbildungsstufe als Proportionalregler, Integralregler oder Proportional-Integral-Regler ausgebildet ist, weisen die bekannten Schaltnetzteile Stabilitätsprobleme auf, wenn die anzusteuernde Last, und damit die Leistungsaufnahme, sehr gering ist, wie dies beispielsweise bei Hifi- oder Fernsehgeräten im Standby-Betrieb der Fall ist. Theoretisch wären hier kurze Einschaltimpulse in relativ großen Zeitabständen zur Leistungsaufnahme ausreichend, um die Spannung an der geringen Last konstant zu halten. Andererseits dürfen die Pausen zwischen einzelnen Ansteuerimpulsen 50 µs nicht überschreiten bzw. darf die Frequenz der Ansteuerimpulse 20 kHz nicht unterschreiten, da dies ein hörbares Brummen des Schaltnetzteiles bewirken würde. Bei Vorgabe einer Frequenz der Ansteuerimpulse größer oder gleich 20 kHz werden die Ansteuerimpulse bei sehr kleinen Lasten allerdings so kurz, daß der üblicherweise als Leistungs-FET ausgebildete Halbleiterleistungsschalter nicht mehr durchschaltet, sondern in den aktiven Bereich übergeht. Im aktiven Bereich bewirken kleine Änderungen bei der Dauer der Ansteuerimpulse große Änderungen der Drainspannung des Leistungs-FET und damit große Änderungen des durch den Leistungs-FET fließenden Laststroms und der durch das Schaltnetzteil aufgenommenen Leistung. Dies führt zu Instabilitäten bei der Nachregelung des durch die Differenzbildungsstufe generierten Ansteuersignals. Es kommt zu einer Grenzschwingung, d.h. der Leistungs-FET wird bedingt durch ein zu kleines Ansteuersignal eine Zeit lang gar nicht und dann wieder für eine Anzahl entsprechend langer Ansteuerimpulse voll durchgeschaltet; das Schaltnetzteil befindet sich im Burst-Betrieb. Dies führt zu unerwünschten akustisch hörbaren Geräuschen des Schaltnetzteils.

Dieses Problem wurde bislang entweder aufwendig und teuer durch akustische Dämpfung der Wikkelteile oder durch Vorsehen einer Mindestlast gelöst, die eine Aufnahmeleistung erforderlich macht, bei der das Schaltnetzteil nicht in den Burst-Betrieb übergeht.

Aus der US-A-4,007,361 ist eine Schaltungsanordnung nach dem Oberbegriff des Anspruches 1 bekannt. Diese Schaltungsanordnung umfasst eine Differenzbildungsstufe zur Bildung eines Differenzsignals aus einem Regelsignal und einem Referenzsignal und zur Erzeugung eines an einer Ausgangsklemme abgreifbaren Ansteuersignals durch Verstärkung des Differenzsignals um einen Verstärkungsfaktor, welcher von dem Ansteuersignal und dem Regelsignal abhängt. Die Differenzbildungsstufe weist ausgangsseitig einen Multiplizierer auf, dem als Eingangssignale das verstärkte Differenzsignal und das über ein Rückkopplungsnetzwerk rückgekoppelte Ansteuersignal zugeführt ist. Des Weiteren ist in der US-A-5,594,631 eine Schaltungsanordnung zur Ansteuerung eines Pulsweitenmodulators beschrieben, wobei die Schaltungsanordnung eine Differenzbildungsstufe aufweist, welcher ein Regelsignal und ein Referenzsignal zugeführt ist. Die Differenzbildungsstufe erzeugt das Differenzsignal zwischen dem Regelsignal und dem Referenzsignal und führt dieses einem Verstärker zu, dessen Verstärkung in Abhängigkeit von dem Regelsignal gesteuert wird.

Aufgabe der vorliegenden Erfindung ist es, eine Schaltungsanordnung zur Ansteuerung eines Pulsweitenmodulators in einem Schaltnetzteil zur Verfügung zu stellen, wodurch ein stabiler Betrieb des Schaltnetzteils auch bei sehr kleinen Lasten, wie im Standby-Betrieb, möglich ist, ohne dass es zu störenden akustischen hörbaren Geräuschen des Schaltnetzteils kommt und sich insbesondere die oben genannten Nachteile nicht ergeben. Diese Aufgabe wird erfindungsgemäß durch eine Schaltungsanordnung mit den Merkmalen des Anspruches 1 bzw. des Anspruches 6 gelöst. Die Unteransprüche definieren jeweils bevorzugte und vorteilhafte Ausführungsformen der vorliegenden Erfindung.

Erfindungsgemäß ist der Verstärkungsfaktor k, mit dem das Differenzsignal der Differenzbildungsstufe verstärkt wird, von dem Ansteuersignal abhängig.

Hierdurch ist ein stabiler Betrieb des Schaltnetzteils auch dann möglich, wenn sich der Leistungs-FET im aktiven Bereich befindet. Die im aktiven Bereich sehr große Verstärkung des Leistungs-FET, die sich durch große Änderungen der Leistungsaufnahme bei geringen Änderungen der Dauer der Ansteuerimpulse bemerkbar macht, wird durch eine Reduktion der Verstärkung in der als Regler dienenden Differenzbildungsstufe kompensiert. Das von der Differenzbildungsstufe gelieferte Ansteuersignal, von dessen Amplitude die Dauer der durch den Pulsweitenmodulator erzeugten Ansteuerimpulse abhängt, dient als Maß für die Reduktion des Verstärkungsfaktors k in der Differenzbildungsstufe. Im Falle eines proportionalen Regelverhaltens der Differenzbildungsstufe besteht ferner die Möglichkeit, das Regelsignal als Maß für die Reduktion des Verstärkungsfaktors k in der Differenzbildungsstufe zu verwenden.

Gemäß einer ersten Ausführungsform der Erfindung ist vorgesehen, daß die Differenzbildungsstufe einen ausgangsseitig an die Ausgangsklemme angeschlossenen Multiplizierer aufweist mit einer ersten Eingangsklemme, der ein verstärktes Differenzsignal zuführbar ist, und mit einer zweiten Eingangsklemme, an die eine Ausgangsklemme eines Rückkopplungszweiges zur Rückkopplung des Ausgangssignals angeschlossen ist.

Das verstärkte Differenzsignal wird vorzugsweise durch einen Differenzierer, der eingangsseitig an die Eingangsklemmen der Differenzbildungsstufe angeschlossen ist, und einen dem Differenzierer nachgeschalteten ersten Verstärker gebildet.

Der Rückkopplungszweig weist einen zweiten Verstärker mit nach oben und unten begrenztem Verstärkungsbereich auf. Der, vorzugsweise linear arbeitende, zweite Verstärker liefert einen konstanten Ausgangswert, solange sich das rückgekoppelte Ansteuersignal unterhalb eines ersten Grenzwertes befindet. Für Ansteuersignale oberhalb dieses ersten Grenzwertes steigt das Ausgangssignal des zweiten Verstärkers solange linear an, bis das Ausgangssignal einen zweiten Grenzwert erreicht, ab dem das Ausgangssignal konstant bleibt. Das von dem zweiten Verstärker gelieferte Ausgangssignal dient über den Multiplizierer zur Gewichtung des konstanten Verstärkungsfaktors des Differenzverstärkers. Der Verstärkungsfaktor k der Differenzbildungsstufe ergibt sich somit aus einer Multiplikation des konstanten Verstärkungsfaktors des ersten Verstärkers mit dem von dem Ansteuersignal abhängigen Verstärkungsfaktor des zweiten Verstärkers, wobei der Verstärkungsfaktor k abnimmt, wenn das Ansteuersignal den zweiten Grenzwert und die Dauer der von dem Ansteuersignal abhängigen Ansteuerimpulse eine bestimmte Mindestdauer unterschreitet.

Vorzugsweise sind der Differenzierer und der erste Verstärker gemeinsam als erster Differenzverstärker ausgebildet.

Eine Ausführungsform der Erfindung sieht vor, den in dem Rückkopplungszweig angeordneten zweiten Verstärker als zweiten Differenzverstärker auszubilden mit einer ersten Eingangsklemme, an der eine den linearen Verstärkungsbereich begrenzende zweite Referenzspannung anlegbar ist, und mit einer zweiten Eingangsklemme, an der das rückgekoppelte Ansteuersignal anlegbar ist.

Vorteilhafte Ausgestaltungen der Erfindung werden nachfolgend anhand von Ausführungsbeispielen in Figuren näher erläutert. Es zeigen:

Figur 1: eine Prinzipdarstellung eines Schaltnetzteils mit Differenzbildungsstufe, Pulsweitenmodulator und Halbleiterleistungsschalter;

Figur 2: erfindungsgemäße Ausführung der Differenzbildungsstufe;

Figuren 3 und 4: Schaltskizzen weiterer Ausführungsformen einer Differenzbildungsstufe; und

Figur 5: Ausgangskennlinie des Verstärkers in der Schaltungsanordnung von Figur 2.

In den Figuren bezeichnen, sofern nicht anders angegeben, gleiche Bezugszeichen gleiche Teile mit gleicher Bedeutung.

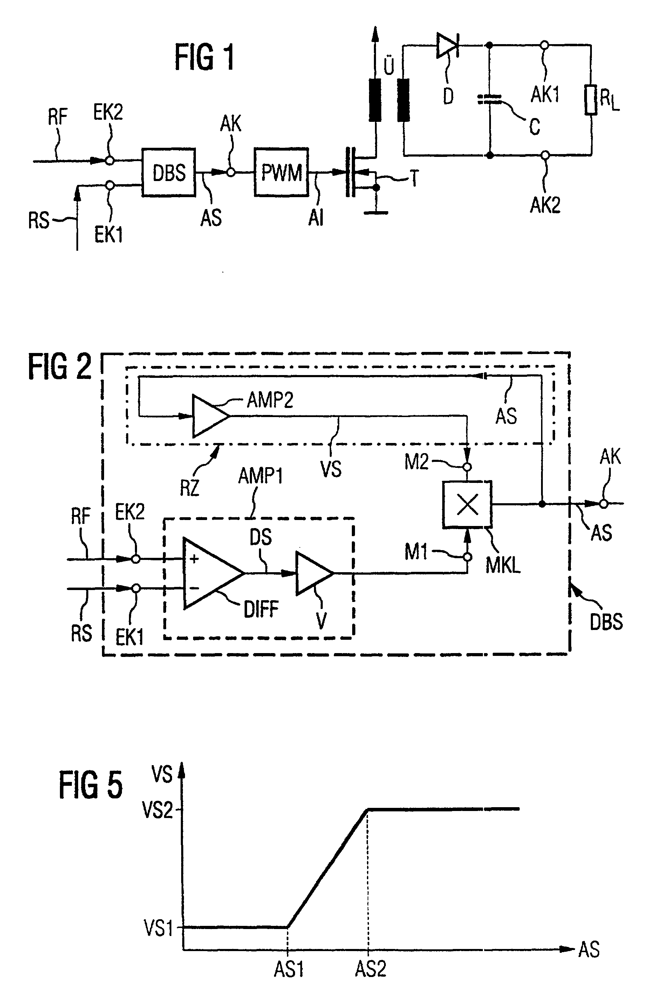

Figur 1 zeigt eine Prinzipdarstellung eines Schaltnetzteiles mit Verwendung der erfindungsgemäßen Schaltungsanordnung zur Ansteuerung eines Pulsweitenmodulators PWM. An Ausgangsklemmen AK1, AK2 des Schaltnetzteiles ist eine veränderliche Last $R_L$ angeschlossen, wobei die über der Last $R_L$ anfallende Ausgangsspannung $U_A$ konstant gehalten werden soll.

Die von dem Schaltnetzteil aufgenommene und an die Last $R_L$ gegebene Leistung bestimmt sich nach Maßgabe der Dauer und der Frequenz von Ansteuerimpulsen AI, die von einem Pulsweitenmodulator PWM zur Ansteuerung eines Halbleiterleistungsschalters T erzeugt werden, der in Reihe zu einer Primärwicklung eines Übertragers Ü geschaltet ist. Während der Dauer der Ansteuerimpulse AI wird Energie durch die Primärwicklung aufgenommen und anschließend über eine Sekundärwicklung und eine Gleichrichteranordnung D, C an die Last $R_L$ abgegeben. Die Frequenz und/oder Dauer der Ansteuerimpulse AI wird in dem Pulsweitenmodulator PWM nach Maßgabe eines an einer Eingangsklemme des Pulsweitenmodulators PWM anliegenden, von der Differenzbildungsstufe DBS gebildeten Ansteuersignals AS erzeugt. Im Falle festgetakteter Schaltnetzteile werden die Ansteuerimpulse AI in konstanten Zeitabständen erzeugt, wobei die Dauer der einzelnen Ansteuerimpulse AI von der Amplitude des am Eingang des Pulsweitenmodulators PWM anliegenden Ansteuersignals AS abhängt.

An einer ersten Eingangsklemme EK1 der Differenzbildungsstufe DBS liegt ein von der Ausgangsspannung $U_A$ abhängiges Regelsignal RS und an einer zweiten Eingangsklemme EK2 liegt ein Referenzsignal RF an. Die Differenzbildungsstufe DBS wirkt als Regler, indem sie das Ansteuersignal AS bei Schwankungen der Ausgangsspannung $U_A$, und damit des Regelsignals RS, nachregelt, bis sich für die Ausgangsspannung $U_A$ bzw. das Regelsignal RS der gewünschte Wert einstellt. Das Regelsignal RS kann beispielsweise über einen Spannungsteiler an der Last $R_L$ oder über eine induktiv mit der Primärwicklung gekoppelte Induktivität mit nachgeschalteter Gleichrichteranordnung erzeugt werden.

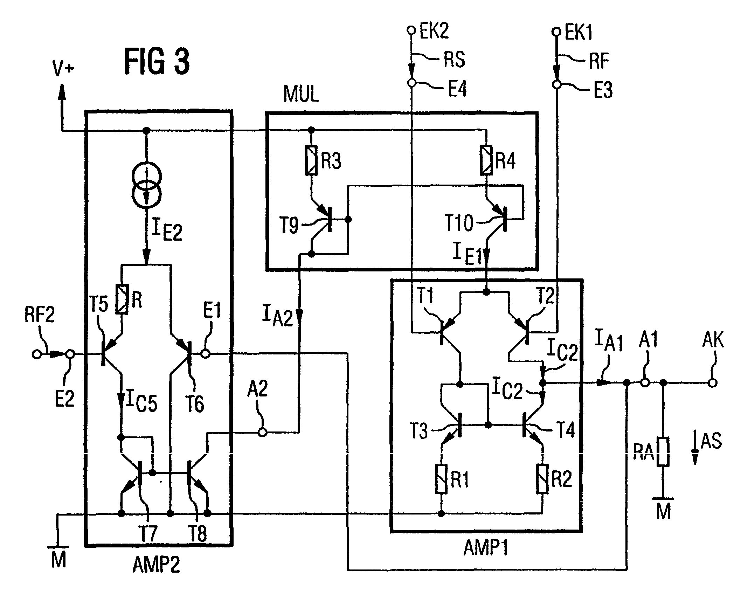

Figur 2 zeigt eine erfindungsgemäße Ausführungsform der Differenzbildungsstufe DBS mit welcher ein stabiler, geräuschfreier Betrieb des Schaltnetzteiles auch für sehr kleine Lasten $R_L$ möglich ist. Die Differenzbildungsstufe DBS besitzt einen mit den Eingangsklemmen EK1, EK2 verbundenen Differenzierer DIFF zur Erzeugung eines Differenzsignals DS aus dem Regelsignal RS und dem Referenzsignal RF mit einem nachgeschalteten ersten Verstärker V zur Verstärkung des Differenzsignals DS. Das verstärkte Differenzsignal wird über eine erste Eingangsklemme M1 einem Multiplizierer MUL zugeführt, der eine weitere Eingangsklemme M2 aufweist, an der ein Rückkopplungszweig RZ zur Rückkopplung des Ansteuersignals AS angeschlossen ist. In den Rückkopplungszweig RZ ist ein zweiter Verstärker AMP2 geschaltet, der ein von dem Ansteuersignal AS abhängiges Ausgangssignal VS zur Gewichtung des an der ersten Eingangsklemme M1 des Multiplizierers MUL anliegenden verstärkten Differenzsignal liefert. Das Ansteuersignal AS ergibt sich aus einer Multiplikation des Ausgangssignals VS des zweiten Verstärkers AMP2 und des verstärkten Differenzsignals und ist an einer Ausgangsklemme des Multiplizierers MUL, die mit der Ausgangsklemme AK der Differenzbildungsstufe DBS verbunden ist, abgreifbar.

Figur 5 zeigt eine Ausgangskennlinie des in dem Ausführungsbeispiel linear arbeitenden zweiten Verstärkers AMP2 in Abhängigkeit von dem an einem Eingang des zweiten Verstärkers AMP2 anliegenden Ansteuersignals AS. Der Verstärker AMP2 bewirkt eine lineare Verstärkung des Ansteuersignals AS, wenn das Ansteuersignal AS Werte zwischen einem unteren Grenzwert AS1 und einem oberen Grenzwert AS2 annimmt. Unterhalb dieses Grenzwertes AS1 liefert der Verstärker AMP2 ein erstes konstantes Ausgangssignal VS1, oberhalb des oberen Grenzwertes AS2 liefert der Verstärker AMP2 ein zweites konstantes Ausgangssignal VS2. Bewirkt der dem Differenzierer DIFF nachgeschaltete erste Verstärker V eine Verstärkung des Differenzsignals DS um einen Faktor k1, so ergibt sich ein Verstärkungsfaktor k der Differenzbildungsstufe DBS zu k1·VS1 für AS<AS1 und k1·VS2 für AS>AS2 mit einem linearen Anstieg des Verstärkungsfaktors von k1·VS1 zu k1·VS2 für Werte des Ansteuersignals AS zwischen AS1 und AS2.

Die erfindungsgemäße Schaltungsanordnung zur Ansteuerung des Pulsweitenmodulators PWM bewirkt eine Reduktion des Gesamtverstärkungsfaktors k für kleine Werte des Ansteuersignals AS. Kleine Werte des Ansteuersignals AS bewirken Ansteuerimpulse AI von sehr kurzer Dauer, wodurch der, vorzugsweise als Leistungs-FET ausgebildete, Halbleiterleistungsschalter T nicht mehr voll durchschaltet, sondern in den aktiven Bereich übergeht. Die sehr große Verstärkung des Leistungs-FET T im aktiven Bereich wird durch Reduktion des Verstärkungsfaktors k der Differenzbildungsstufe DBS wenigstens teilweise kompensiert, wodurch das Schaltnetzteil stabil betrieben wird, selbst wenn sich der Leistungs-FET im aktiven Bereich befindet.

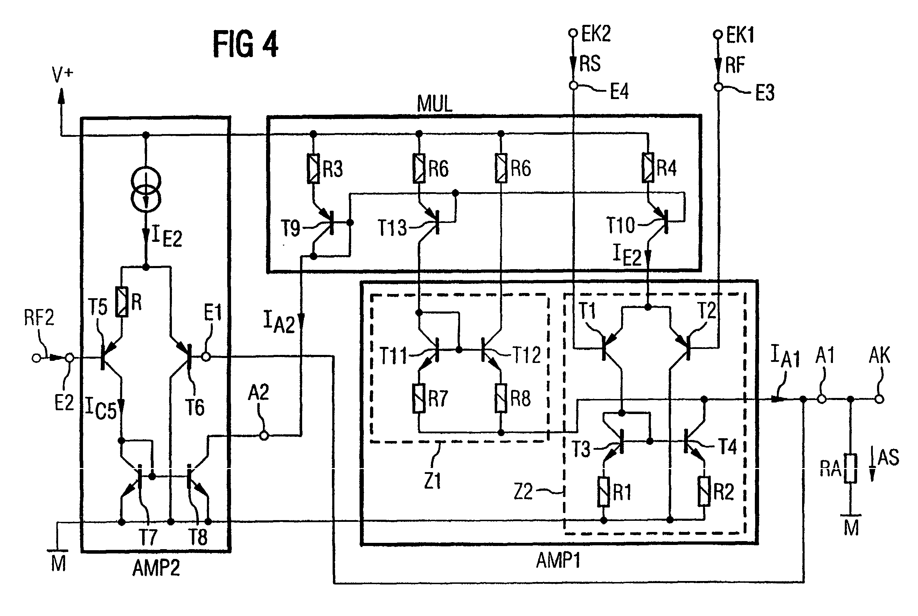

Die Figuren 3 und 4 zeigen Ausführungsbeispiele anhand von Schaltskizzen zur Realisierung einer Differenzbildungsstufe, welche jedoch nicht Gegenstand der vorliegenden Erfindung sind.

Der zweite Verstärker AMP2 ist als Differenzverstärker ausgebildet und zwischen einem Versorgungspotential V+ und Bezugspotential M verschaltet. Der Differenzverstärker besitzt eine an Versorgungspotential V+ geschaltete Stromquelle, die einen konstanten Eingangsstrom $I_{E2}$ liefert und eine der Stromquelle nachgeschaltete Parallelschaltung eines ersten und zweiten Transistors T5, T6, wobei zu der Laststrecke des ersten Transistors T5 ein Widerstand R in Reihe geschaltet ist. Die Basisanschlüsse der Transistoren T5, T6 bilden erste und zweite Eingänge E:L, E2 des Differenzverstärkers, wobei an dem Basisanschluß des Transistors T5 ein zweites Referenzsignal RF2 und an dem Basisanschluß des zweiten Transistors T6 das von dem Ausgang zurückgekoppelte Ansteuersignal AS anliegt.

Der Kollektorstrom $I_{C5}$ des ersten Transistors T5 ist maximal (gleich $I_{E2}$), wenn das Ansteuersignal AS, im vorliegenden Fall die über einem Ausgangswiderstand RA anliegende Spannung, größer ist als RF2+I·R. Unterhalb dieses Grenzwertes für das Ansteuersignal AS nimmt der Kollektorstrom $I_{C5}$ kontinuierlich gemäß der Gleichung:

$$I_{C5} = (AS-RF2)/R$$

ab. Der Kollektorstrom $I_{C5}$ des ersten Transistors T5 bestimmt über eine Stromspiegelanordnung T7, T8 einen an einer Ausgangsklemme abgreifbaren Ausgangsstrom $I_{A2}$ des zweiten Differnzverstärkers AMP2, wobei der Ausgangsstrom $I_{A2}$ über das Flächenverhältnis der beiden den Stromspiegel bildenden Transistoren T7, T8 mit dem Kollektorstrom $I_{C5}$ des ersten Transistors T5 in Bezug steht. Dieser Ausgangsstrom $I_{A2}$ bestimmt über einen weiteren Stromspiegel R3, T9, R4, T10 einen Eingangsstrom $I_{E1}$ eines ersten Differenzverstärkers AMP1, wobei letzterer die Funktion des Differenzierers DIFF und des ersten Verstärkers V gemäß Figur 2 erfüllt. Die Basisanschlüsse eines ersten und zweiten Transistors T1, T2 des Differenzverstärkers bilden erste und zweite Eingänge E3, E4 des ersten Differenzverstärkers und sind mit der ersten und zweiten Eingangsklemme EK1, EK2 verbunden. Dem ersten und zweiten Transistor T1, T2 ist eine weitere Stromspiegelanordnung T3, R1, T4, R2 als Last nachgeschaltet. Ein an einer Ausgangsklemme A1 abgreifbarer Ausgangsstrom $I_{A1}$ des ersten Differenzverstärkers AMP1 ergibt sich aus der Differenz zwischen dem Kollektorstroms $I_{C2}$ des zweiten Transistors T2 des Differenzverstärkers und dem Kollektorstrom $I_{C4}$ des dem zweiten Transistor T2 nachgeschalteten Stromspiegeltransistors T4.

Der Ausgangsstrom $I_{A1}$ des ersten Differenzverstärkers AMP1 ist abhängig von der Differenz des Regelsignals RS zu dem Referenzsignal RF, wobei der Ausgangsstrom $I_{A1}$ maximal dem Eingangsstrom $I_{E1}$ beträgt, welcher wiederum proportional zu dem Ausgangsstrom $I_{A2}$ des zweiten Differenzverstärkers AMP2 ist. Die Verstärkung des Differenzverstärkers AMP1 wird damit über den Ausgangsstrom $I_{A2}$ des zweiten Differenzverstärkers AMP2 abhängig von dem Ansteuersignal AS geregelt, wobei beispielsweise eine Verdoppelung des Ausgangsstromes $I_{A2}$ des zweiten Differenzverstärkers AMP2 eine Verdoppelung der Verstärkung des Differenzverstärkers AMP1 bewirkt. Der Stromspiegel R3, T9, R4, T10 bildet den Ausgangsstrom $I_{A2}$ des zweiten Differenzverstärkers auf den Eingangsstrom $I_{E1}$ des ersten Differenzvertärkers AMP1 ab.

Zwischen dem Kollektor des zweiten Transistors T2 des ersten Differenzverstärkers AMP1 und Bezugspotential M ist ein Ausgangswiderstand $R_A$ geschaltet, über welchem das Ausgangssignal AS anliegt. Die Differenzbildungsstufe besitzt bei Verwendung eines Ausgangswiderstandes $R_A$ ein proportionales Regelverhalten; ein integrales Regelverhalten könnte durch Ersetzen des Ausgangswiderstandes $R_A$ durch einen Kondensator erreicht werden.

Figur 4 zeigt eine weitere Differenzbildungsstufe DBS, bei welcher der Differenzverstärker AMP1 zusätzlich eine an den Ausgang angeschlossene, als Stromspiegel T11, T12, R7, R8 verschaltete Stromquelle aufweist, die einen von dem Ausgangsstrom $I_{A2}$ des zweiten Differenzverstärkers AMP2 abhängigen Strom an einen Ausgang A1 liefert. Die Stromquelle T11, T12, R7, R8 ist hierzu über einen Transistor T13 und einen Widerstand R6 an die Stromspiegelanordnung R3, T9, R4, T10 zwischen Differenzverstärker AMP2 und Differrenzverstärker AMP1 geschaltet. Der Kollektor des zweiten Transistors T2 des Differenzverstärkers AMP1 ist bei dieser Ausführungsform direkt an Bezugspotential M geschaltet. Dies bewirkt, daß der als Last des Differenzverstärkers dienende Stromspiegel T3, T4, R1, R2 keinen Strom an den Ausgang liefert, sondern lediglich einen von dem Eingangsstrom $I_E$ und der Differenz des Regelsignals RS zu dem Referenzsignal RF abhängigen Strom aufnehmen kann. Der Ausgangsstrom $I_{A2}$ ergibt sich aus der Differenz des von der Stromquelle T11, T12, R7, R8 gelieferten Stromes zu den von dem Stromspiegel T3, T4, R1, R2 aufgenommenen Stromes. Der Differenzverstärker AMP1 zeigt bei dieser Ausführungsform das Verhalten eines Verstärkers mit Strom-Offset am Ausgang.

Der erste und zweite Differenzverstärker AMP1, AMP2 funktionieren gemäß Figur 3 und Figur 4 als gesteuerte Stromquellen, wobei der Ausgangsstrom $I_{A2}$ des als zweite gesteuerte Stromquelle dienenden zweiten Differenzverstärkers AMP2 den maximalen Eingangsstrom $I_{E1}$ und damit den maximalen Ausgangsstrom $I_{A1}$ des als erste gesteuerte Stromquelle dienenden ersten Differenzverstärkers AMP1 bestimmt. Reduziert sich der Ausgangsstrom $I_{A2}$ des zweiten Differenzverstärkers AMP2 bedingt durch eine absinkendes Ansteuersignal AS, so reduziert: sich bei gleichbleibendem Verhältnis von Regelsignal RS zu Referenzsignal RF auch der Ausgangsstrom $I_{A1}$ des zweiten Differenzverstärkers, die Verstärkung des ersten Differenzverstärkers AMP1 und damit der Verstärkungsfaktor k der Differenzbildungsstufe DBS. Die beiden gesteuerten Stromquellen sind über eine Stromspiegelanordnung T9, R3, T10, R4; T9, R3, T10, R4, T13, R6 gekoppelt. Das Ansteuersignal AS ergibt sich in den vorliegenden Ausführungsbeispielen aus dem durch den Ausgangsstrom $I_{A1}$ an einem Widerstand RA, der an den Ausgang A1 des ersten Differenzverstärkers AMP1 angeschlossen ist, hervorgerufenen Spannungsabfall.

In den Figuren 4 und 5 bezeichnen die Bezugszeichen T1, T2, T5, T6, T9, T10 und T13 pnp-Bipolartransistoren, die Bezugszeichen T3, T4, T7, T8, T11, T12 bezeichnen npn-Bipolartransistoren. Die Bezugszeichen R1 bis R8 bezeichnen Widerstände.

Bezugszeichenliste

| | |
|---|---|
| AI | Ansteuerimpulse |
| A1, A2 | Ausgänge |
| AK | Ausgangsklemme |
| AK1, AK2 | Ausgangsklemmen |
| AMP1 | Differenzverstärker |
| AMP2 | Differenzverstärker |
| AS | Ansteuersignal |
| C | Kapazität |
| D | Diode |
| DBS | Differenzbildungsstufe |
| DIFF | Differenzierer |
| E1, E3 | erste Eingsngsklemmen |
| E2, E4 | zweite Eingangsklemmen |
| EK1 | erste Eingangsklemme |
| EK2 | zweite Eingangsklemme |
| $I_{C5}, I_{C2}, I_{C4}$ | Kollektorströme |
| M | Bezugspotential |
| M1 | erste Eingangsklemme |
| M2 | zweite Eingangsklemme |
| MUL | Multiplizierer |
| PWM | Pulsweitenmodulator |
| R1 - R8 | Widerstände |
| RA | Ausgangswiderstand |
| RF | Referenzsignal |
| RF2 | zweites Referenzsignal |
| $R_L$ | Last |
| RS | Regelsignal |
| RZ | Rückkopplungszweig |
| T | Leistungs-FET |
| T1 - T13 | Transistoren |
| Ü | Übertrager |
| V | Verstärker |
| V+ | Versorgungspotential |
| VS | Ausgangssignal |

**Patentansprüche**

1. Schaltungsanordnung zur Ansteuerung des Pulsweitenmodulators (PWM) in einem Schaltnetzteil mit einer Differenzbildungsstufe (DBS) zur Bildung eines Differenzsignals (DS) aus einem einer ersten Eingangsklemme (EK1) zuführbaren Regelsignal (RS) und einem einer zweiten Eingangsklemme (EK2) zuführbaren Referenzsignal (RF) und zur Erzeugung eines an einer Ausgangsklemme (AK) abgreifbaren Ansteuersignals (AS) durch Verstärkung des Differenzsignals (DS) um einen Verstärkungsfaktor k, welcher von dem Ansteuersignal (AS) und/oder dem Regelsignal (RS) abhängig ist, wobei die Differenzbildungsstufe (DBS) einen ausgangsseitig an die Ausgangsklemme angeschlossenen Multiplizierer (MUL) aufweist mit einer ersten Eingangsklemme (M1), dem das verstärkte Differenzsignal zuführbar ist, und mit einer zweiten Eingangsklemme (M2), an die eine Ausgangsklemme eines Rückkopplungszweiges (RZ) zur Rückkopplung des Ansteuersignals (AS) angeschlossen ist, **dadurch gekennzeichnet, daß** der Rückkopplungszweig (RZ) einen Verstärker (AMP2) mit nach oben und unten begrenztem Verstärkungsbereich aufweist, wobei der Verstärker (AMP2) in Abhängigkeit von dem rückgekoppelten Ansteuersignal (AS) ein erstes konstantes Ausgangssignal (VS1) erzeugt, falls das Ansteuersignal (AS) einen Wert unterhalb eines ersten Grenzwerts (AS1) besitzt, während der Verstärker (AMP2) ein zweites konstantes Ausgangssignal (VS2) erzeugt, falls das Ansteuersignal (AS) einen Wert oberhalb eines zweiten Grenzwerts (AS2) besitzt.

2. Schaltungsanordnung nach Anspruch 1, **dadurch gekennzeichnet, daß** der ersten Eingangsklemme (M1) des Multiplizierers ein eingangsseitig an die Eingangsklemmen (EK1, EK2) angeschlossener Differenzierer (DIFF) zur Bildung des Differenzsignals (DS) mit nachgeschaltetem Verstärker (V) vorgeschaltet ist.

3. Schaltungsanordnung nach Anspruch 2, **dadurch gekennzeichnet, daß** der Differenzierer (DIFF) und der Verstärker (V) als erster Differenzverstärker (AMP1) ausgebildet sind.

4. Schaltungsanordnung nach Anspruch 3, **dadurch gekennzeichnet, daß** der Verstärker des Rückkopplungszweiges (RZ) als zweiter Differenzverstärker (AMP2) ausgebildet ist.

5. Schaltungsanordnung nach einem der vorhergehenden Ansprüche, **dadurch gekennzeichnet, daß** der Verstärker (AMP2) des Rückkopplungszweigs (RZ) als linear arbeitender Verstärker ausgestaltet ist, wobei der Verstärker für Werte des Ansteuersignals (AS) oberhalb des ersten Grenzwerts (AS1) und unterhalb des zweiten Grenzwerts (AS2) ein mit zunehmendem Ansteuersignalwert linear ansteigendes Ausgangssignal (VS) erzeugt.

**Claims**

1. Circuit arrangement for driving the pulse width modulator (PWM) in a switched-mode power supply having a difference formation stage (DBS) for forming a difference signal (DS) from a control signal (RS), which can be supplied to a first input terminal (EK1) and a reference signal (RF), which can be supplied to a second input terminal (EK2), and for producing a drive signal (AS), which can be tapped off at an output terminal (AK), by amplifying the difference signal (DS) by a gain factor k which is dependent: on the drive signal (AS) and/or on the control signal (RS),
where the difference formation stage (DBS) has a multiplier (MUL), whose output is connected to the output terminal, having a first input terminal (M1), to which the amplified difference signal can be supplied, and having a second input terminal (M2) to which an output terminal of a feedback path (RZ) for feeding back the drive signal (AS) is connected, **characterized**
**in that** the feedback path (RZ) has an amplifier (AMP2) with a gain range which is limited at the top and bottom, the amplifier (AMP2) producing, on the basis of the fed-back drive signal (AS), a first constant output signal (VS1) if the drive signal (AS) has a value below a first limit value (AS1), whereas the amplifier (AMP2) produces a second constant output signal (VS2) if the drive signal (AS) has a value above a second limit value (AS2).

2. Circuit arrangement according to Claim 1, **characterized**
**in that** a differentiator (DIFF) for forming the difference signal (DS), whose input is connected to the input terminals (EK1, EK2), is connected upstream of the first input terminal (M1) of the multiplier and has an amplifier (V) connected downstream.

3. Circuit arrangement according to Claim 2, **characterized**
**in that** the differentiator (DIFF) and the amplifier (V) are in the form of a first differential amplifier (AMP1).

4. Circuit arrangement according to Claim 3, **characterized**
**in that** the amplifier in the feedback path (RZ) is in the form of a second differential amplifier (AMP2).

5. Circuit arrangement according to one of the preceding claims, **characterized**
**in that** the amplifier (AMP2) in the feedback path (RZ) is in the form of a linearly operating amplifier, where, for values of the drive signal (AS) above the first limit value (AS1) and below the second limit value (AS2), the amplifier produces an output signal (VS) which rises linearly as the drive signal value increases.

## Revendications

1. Montage pour commander le modulateur d'impulsions en durée (PMW) dans une partie de réseau commutée comportant un étage de formation de différence (DBS) pour former un signal de différence (DS) à partir d'un signal de régulation (RS) pouvant être envoyé à une première borne d'entrée (EK1), et un signal de référence (RF) pouvant être envoyé à une seconde borne d'entrée (EK2) et pour produire un signal de commande (AS) pouvant être prélevé sur une borne de sortie (AK), par amplification du signal de différence (DS), et ce avec un facteur d'amplification k, qui dépend du signal de commande (AS) et/ou du signal de régulation (RS), et dans lequel l'étage de formation de différence (DBS) comporte un multiplicateur (MUL) raccordé côté sortie à la borne de sortie et comportant une première borne d'entrée (M1), à laquelle peut être envoyé le signal de différence amplifié, et une seconde borne d'entrée (M2), à laquelle est raccordée une borne de sortie d'une branche de réaction (RZ) pour réaliser un couplage par réaction du signal de commande (AS), **caractérisé en ce que** la branche de réaction (RZ) possède un amplificateur (AMP2) possédant une gamme d'amplification limitée vers le haut et vers le bas, l'amplificateur (AMP2) produisant, en fonction du signal de commande (AS) couplé par réaction, un premier signal de sortie constant (VS1) dans le cas où le signal de commande (AS) possède une valeur inférieure à une première valeur limite (AS1), tandis que l'amplificateur (AMP2) produit un second signal de sortie constant (VS2) dans le cas où le signal de commande (AS) possède une valeur supérieure à une seconde valeur limite (AS2).

2. Montage selon la revendication 1, **caractérisé en ce qu'**en amont de la première borne d'entrée (M1) du multiplicateur est branché un circuit différenciateur (DIFF) qui est raccordé côté entrée aux bornes d'entrée (EK1, EK2) et sert à former le signal de différence (DF) et en aval duquel est branché un amplificateur (V).

3. Montage selon la revendication 2, **caractérisé en ce que** le circuit différentiateur (DIFF) et l'amplificateur (V) sont formés en tant que premier amplificateur différentiel (AMP1).

4. Montage selon la revendication 3, **caractérisé en ce que** l'amplificateur de la branche de réaction (RZ) est formé en tant que second amplificateur différentiel.

5. Montage selon l'une des revendications précédentes, **caractérisé en ce que** l'amplificateur (AMP2) de la branche de réaction (RZ) est agencé sous la forme d'un amplificateur travaillant linéairement, l'amplificateur produisant, pour des valeurs du signal de commande (AS) supérieures à la première valeur limite (AS1) et au-dessous de la seconde valeur limite (AS2), un signal de sortie (VS) qui augmente linéairement lorsque la valeur du signal de commande augmente.

**FIG 1**

RF EK2

RS EK1

DBS

AK

PWM

AS

AI

T

Ü

D

C

AK1

AK2

R$_L$

**FIG 2**

AMP2

RZ

AMP1

VS

M2

DS

DIFF

V

M1

MKL

AK

AS

DBS

RF EK2

RS EK1

AS

**FIG 5**

VS

VS2

VS1

AS1    AS2    AS

FIG 3

FIG 4